(19) **Europäisches Patentamt**

**European Patent Office**

**Office européen des brevets**

(11) **EP 1 094 465 A1**

(12) **EUROPÄISCHE PATENTANMELDUNG**

(43) Veröffentlichungstag:
  **25.04.2001 Patentblatt 2001/17**

(51) Int Cl.[7]: **G11C 7/06**, G11C 16/26

(21) Anmeldenummer: **99120074.2**

(22) Anmeldetag: **20.10.1999**

(84) Benannte Vertragsstaaten:
  **AT BE CH CY DE DK ES FI FR GB GR IE IT LI LU**
  **MC NL PT SE**
  Benannte Erstreckungsstaaten:
  **AL LT LV MK RO SI**

(71) Anmelder: **Infineon Technologies AG**
  **81669 München (DE)**

(72) Erfinder:
  • **Weder, Uwe, Dr.**
    **84072 Au/Hallertau (DE)**
  • **Viehmann, Hans-Heinrich**
    **81739 München (DE)**

(74) Vertreter: **Hermann, Uwe, Dipl.-Ing. et al**
  **Epping, Hermann & Fischer**
  **Ridlerstrasse 55**
  **80339 München (DE)**

(54) **Speichereinrichtung**

(57) Es wird eine Speichereinrichtung mit Speicherzellen zum Speichern von Daten beschrieben. Die beschriebene Speichereinrichtung zeichnet sich dadurch aus, daß eine Stromabschalteinrichtung vorgesehen ist, die einen vorhandenen Stromfluß durch die auszulesende Speicherzelle im Ansprechen auf das Erkennen des Speicherzellen-Inhaltes unterbindet und/oder daß eine Entladevorrichtung vorgesehen ist, welche einen vor dem Auslesen der Speicherzelle vorzuladenden Knotenpunkt in dieser teilweise wieder entlädt.

**Beschreibung**

Die vorliegende Erfindung betrifft eine Vorrichtung gemäß den Oberbegriffen der Patentansprüche 1 und 6, d.h. eine Speichereinrichtung mit Speicherzellen zum Speichern von Daten, und mit einem Leseverstärker, durch welchen anhand der Größe und/oder der Richtung eines sich beim Auslesen einer Speicherzelle durch diese einstellenden Stromflusses der Inhalt der betreffenden Speicherzelle ermittelbar ist.

Speichereinrichtungen dieser Art sind seit vielen Jahren in unzähligen Ausführungsformen bekannt.

Bei der Entwicklung von Speichereinrichtungen wird wie auch bei sonstigen elektrischen Schaltungen mit großem Aufwand versucht, den Energieverbrauch möglichst gering zu halten oder weiter abzusenken. Hier wurden insbesondere in den letzten Jahren schon beträchtliche Erfolge erzielt.

Für bestimmte Anwendungen ist der Energieverbrauch von Speichereinrichtungen aber immer noch zu hoch.

Eine dieser Anwendungen sind Speichereinrichtungen für den Einsatz in kontaktlosen Chipkarten.

Kontaktlose Chipkarten treten bekanntlich mit anderen Einrichtungen ausschließlich drahtlos in Verbindung. Selbst die für ihren Betrieb benötigte Energie wird drahtlos übertragen; sie wird aus von der Chipkarte empfangenen elektromagnetischen Schwingungen extrahiert und in einem Kondensator zwischengespeichert. Die in Chipkarten zwischenspeicherbare Energie ist jedoch insbesondere wegen der sehr beschränkten Speichermöglichkeiten äußerst gering. Dementsprechend müssen in drahtlosen Chipkarten enthaltende Bauteile mit einem Minimum an Energie betreibbar sein. Herkömmliche Speichereinrichtungen erfüllen diese Forderung noch nicht.

Der vorliegenden Erfindung liegt daher die Aufgabe zugrunde, die Speichereinrichtung gemäß dem Oberbegriff der Patentansprüche 1 und 6 derart weiterzubilden, daß diese mit einem Minimum an Energie bestimmungsgemäß betreibbar sind.

Diese Aufgabe wird durch die in den kennzeichnenden Teilen der Patentansprüche 1 und 6 beanspruchten Merkmale gelöst.

Demnach ist vorgesehen,

- daß eine Stromabschalteinrichtung vorgesehen ist, die einen vorhandenen Stromfluß durch die auszulesende Speicherzelle im Ansprechen auf das Erkennen des Speicherzellen-Inhaltes unterbindet (kennzeichnender Teil des Patentanspruchs 1) und/oder

- daß eine Entladevorrichtung vorgesehen ist, welche einen vor dem Auslesen der Speicherzelle vorzuladenden Knotenpunkt in dieser teilweise wieder entlädt (kennzeichnender Teil des Patentanspruchs 6).

Die in Patentanspruch 1 beanspruchte Maßnahme hat den positiven Effekt, daß die Zeit, während welcher in der Speichereinrichtung und im Leseverstärker elektrische Ströme fließen, auf ein Minimum reduzierbar ist.

Die in Patentanspruch 6 beanspruchte Maßnahme hat den positiven Effekt, daß sich dadurch die zum Auslesen der Speicherzelle erforderliche Zeit erheblich verkürzt; dadurch muß die Speichereinrichtung und/oder ein diese enthaltendes System weniger lange in Betrieb genommen werden als es bisher der Fall ist.

In beiden Fällen sinkt der Energieverbrauch der Speichereinrichtung; solche Speichereinrichtungen lassen sich mit einem Minimum an Energie bestimmungsgemäß betreiben.

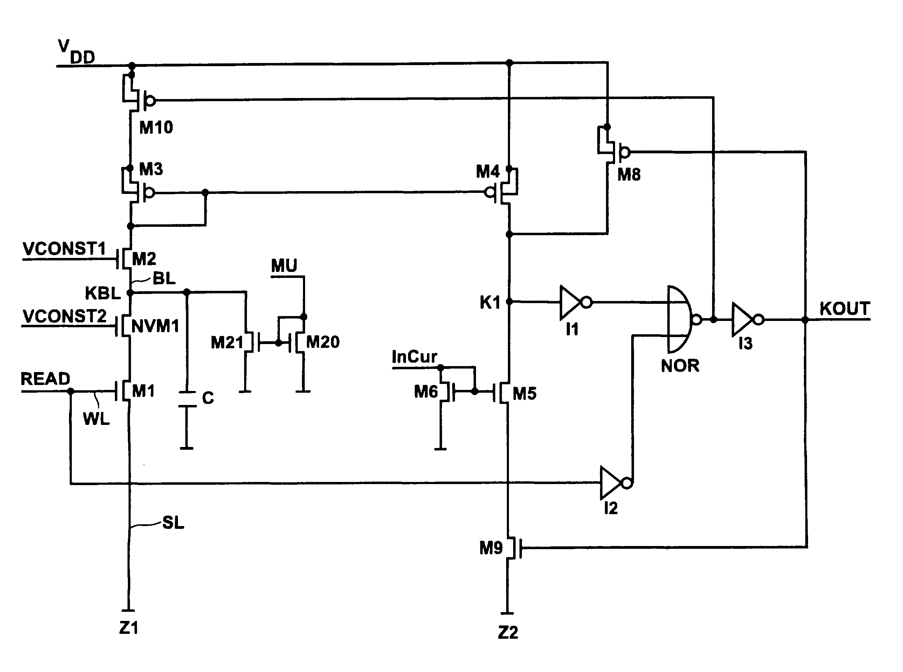

Vorteilhafte Weiterbildungen der Erfindung sind den Unteransprüchen, der nachfolgenden Beschreibung und der Figur entnehmbar.

Die Figur zeigt einen Ausschnitt aus der nachfolgend näher beschriebenen Speichereinrichtung.

Bei der nachfolgend näher betrachteten Speichereinrichtung handelt es sich um ein EEPROM. Hierauf besteht allerdings keine Einschränkung. Die nachfolgend beschriebenen Besonderheiten des EEPROM lassen sich auch bei beliebigen anderen nichtflüchtigen oder flüchtigen (Halbleiter-)Speichereinrichtungen wie beispielsweise Flash-Speichern, RAMs etc. nutzbringend einsetzen.

Der Aufbau des nachfolgend näher betrachteten EEPROM ist in der Figur veranschaulicht.

In der Figur ist von den vielen Speicherzellen, die ein EEPROM üblicherweise aufweist, der Übersichtlichkeit halber nur eine einzige Speicherzelle dargestellt.

Die gezeigte Speicherzelle besteht aus einem mit dem Bezugzeichen NVM1 bezeichneten Speichertransistor und einem dazu in Reihe geschalteten, mit dem Bezugzeichen M1 bezeichneten Auswahltransistor. Der Auswahltransistor M1 ist über eine sogenannte Sourceleitung SL mit Masse verbunden, und der Speichertransistor NVM1 ist über eine sogenannte Bitleitung BL und Transistoren M2, M3 und M10 mit einem Versorgungsspannungspotential $V_{DD}$ verbunden.

Der Auswahltransistor M1 wird über eine sogenannte Wortleitung WL durch ein Lesesignal READ ansteuert. Die Transistoren NVM1 und M2 werden durch Signale VCONST1 (Transistor M2) und VCONST2 (Transistor NVM1) angesteuert; die genannten Signale sind - jedenfalls während des später noch näher beschriebenen Vorladens und/oder Auslesens - konstant und betragen im betrachteten Beispiel 1,2 V (VCONST1) bzw. 2 V (VCONST2).

Der Transistor M2 ist ein Precharge-Transistor und dient zum Aufladen eines zwischen ihm und dem Transistor NVM1 liegenden Knotenpunktes KBL (der zwischen ihm und dem Transistor NVM1 verlaufenden Bitleitung BL) auf ein vorbestimmtes Potential.

Der Transistor M3 dient zur Spiegelung des über die Bitleitung BL fließenden Stromes in einen später noch genauer beschriebenen Zweig Z2.

Der Transistor M10 dient dazu, bei Bedarf die Verbindung des ihn enthaltenden Zweiges (den nachfolgend definierten Zweig Z1) mit dem Versorgungsspannungspotential $V_{DD}$ aufzutrennen (das Fließen eines Stromes durch den Zweig Z1 zu unterbinden).

Der vorstehend beschriebene Schaltungsteil, d.h. der die Transistoren M10, M3, M2, NVM1 und M1 enthaltende Schaltungszweig bildet den bereits erwähnten (ersten) Zweig Z1.

Parallel zu diesem ersten Zweig Z1 liegt der ebenfalls bereits erwähnte zweite Zweig Z2. Dieser zweite Zweig Z2 besteht aus einer Reihenschaltung von Transistoren M4, M5, und M9, wobei der Transistor M4 mit dem Versorgungsspannungspotential $V_{DD}$ verbunden ist, und wobei der Transistor M9 mit Masse verbunden ist.

Die Transistoren M4 und M5 werden so angesteuert, daß sie jeweils von ganz bestimmten Strömen durchflossen werden, und zwar

- der Transistor M4 von einem Strom, der dem durch den ersten Zweig Z1 fließenden Strom entspricht (die Transistoren M3 und M4 bilden einen Stromspiegel, durch welchen bewirkt wird, daß durch den Transistor M4 ein Strom fließt, dem durch den Transistor M3 fließenden Strom entspricht), und

- der Transistor M5 von einem Referenzstrom InCur, der durch einen Transistor M6 zum Fließen gebracht wird (die Transistoren M5 und M6 bilden einen Stromspiegel, durch welchen bewirkt wird, daß durch den Transistor M5 ein Strom fließt, der dem durch den Transistor M6 fließenden Strom entspricht).

Der Transistor M9 dient "nur" dazu, den zweiten Zweig Z2 bei Bedarf aufzutrennen (das Fließen eines Stromes durch den zweiten Zweig Z2 zu unterbinden).

Die durch die Transistoren M4 und M5 fließenden Ströme treffen am einem zwischen den Transistoren M4 und M5 liegenden Knotenpunkt K1 aufeinander. An diesem Knotenpunkt K1 stellt sich ein vom Größenverhältnis der Ströme abhängendes Potential ein. Die Höhe dieses Potentials repräsentiert den Inhalt der auszulesenden Speicherzelle, ist aber noch nicht das den Inhalt der Speicherzelle repräsentierende Ausgangssignal der Anordnung.

Das Potential des Knotenpunktes K1 wird durch einen ersten Inverter I1 invertiert. Das Ausgangssignal des ersten Inverters I1 wird einem NOR-Glied NOR zugeführt und dort einer NOR-Verknüpfung mit dem bereits erwähnten und durch einen zweiten Inverter I2 invertierten READ-Signal unterzogen. Das Ausgangssignal des NOR-Gliedes NOR wird zur Ansteuerung des Transistors M10 verwendet und ferner einem dritten Inverter I3 zugeführt. Das Ausgangssignal dieses dritten Inverters I3 wird als Ausgangssignal KOUT der gezeigten Anordnung verwendet.

KOUT hat im betrachteten Beispiel

- den Wert 0,

  - wenn das Signal READ den Pegel 1 aufweist, also ein Auslesen der Speicherzelle erfolgt, und der Transistor NVM1 so programmiert ist, daß er einen niedrige Threshold-Spannung aufweist, also während des Auslesevorganges durchschaltet, und

- den Wert 1,

  - wenn das Signal READ den Pegel 1 aufweist, also ein Auslesen der Speicherzelle erfolgt, und der Transistor NVM1 so programmiert ist, daß er eine hohe Threshold-Spannung aufweist, also während des Auslesevorganges sperrt, oder
  - wenn und so lange das Signal READ den Pegel 0 aufweist, also kein Auslesen der Speicherzelle erfolgt.

Das Signal KOUT wird auch dazu verwendet, den im zweiten Zweig liegenden Transistor M9 und einen parallel zum Transistor M4 angeordneten Transistor M8 anzusteuern.

Das Auslesen der Speicherzelle erfolgt in zwei Stufen, nämlich einer Vorlade-Stufe und einer sich daran anschließenden Detektions-Stufe.

Die Vorlade-Stufe ist eine Vorbereitung für den (in der Detektions-Stufe) erfolgenden Lesevorgang; das (Lese-)Signal READ weist in der Vorlade-Stufe noch den Pegel 0 auf. Ziel der Vorlade-Stufe ist es, den Knotenpunkt KBL auf ein bestimmtes Potential vorzuladen. In der Vorlade-Stufe werden die im ersten Zweig Z1 enthaltenen Transistoren M10, M3, M2, NVM1 und M1 so angesteuert, daß die Transistoren M10, M3 und M2 leiten, und daß der Transistor M1 sperrt. Dadurch, und weil der Knotenpunkt KBL über eine parasitäre Kapazität C mit Masse verbunden ist, wird der Knotenpunkt KBL (zunächst über einen sogenannten Strong-Inversion-Strom, und anschließend über einen sogenannten Weak-Inversion-Strom) asymptotisch auf VCONST1 aufgeladen.

Da der Transistor M1 sperrt, kann in der Vorladestufe über den ersten Zweig Z1 kein, oder jedenfalls kein nennenswerter Strom fließen.

Dadurch sperrt der Transistor M4, so daß auch im zweiten Zweig Z2 kein, oder jedenfalls kein nennenswerter Strom fließt.

Aufgrund des Pegels 0 des Signals READ, hat das Ausgangssignal des zweiten Inverters I2 den Pegel 1, das Ausgangssignal des NOR-Gliedes NOR den Pegel 0, und das Ausgangssignal des dritten Inverters I3 (und damit auch das Ausgangssignal KOUT der Anordnung) den Pegel 1.

Durch den Pegel 0 des Ausgangssignals des NOR-Gliedes NOR wird bzw. bleibt der dadurch angesteuerte (PMOS-)Transistor M10 leitend; durch den Pegel 1 von KOUT werden bzw. bleiben der dadurch angesteuerte (NMOS-)Transistor M9 leitend und der ebenfalls dadurch angesteuerte (PMOS-)Transistor M8 sperrend.

Über den Transistor M9 kann der Knotenpunkt K1 des zweiten Zweiges Z2 auf Massepotential gezogen werden.

An die Vorlade-Stufe schließt sich die bereits erwähnte Detektions-Stufe an, in welcher das eigentliche Auslesen der Speicherzelle erfolgt; das Lesesignal READ weist jetzt dem Pegel 1 auf. In der Detektions-Stufe werden die im ersten Zweig Z1 enthaltenen Transistoren so angesteuert, daß sie bei Anliegen geeigneter Spannungen an den Source- oder Drain-Anschlüssen durchschalten. Ob tatsächlich alle Transistoren im ersten Zweig Z1 durchschalten, hängt vom Zustand des Transistors NVM1 ab. Ist der Transistor NVM1 so programmiert, daß er eine hohe Threshold-Spannung aufweist, so sperrt der Transistor NVM1; ist der Transistor NVM1 so programmiert, daß er eine niedrige Threshold-Spannung aufweist, so leiten der Transistor NVM1 und die anderen im ersten Zweig Z1 vorgesehenen Transistoren. Diese Vorgänge sind bekannt und bedürfen keiner näheren Erläuterung.

Wenn der Transistor NVM1 so programmiert ist, daß er in der Detektions-Stufe sperrt, kann über den ersten Zweig Z1 kein Strom fließen.

Dadurch behält der Transistor M4 im zweiten Zweig seinen Zustand unverändert bei. D.h., er bleibt wie in der Vorlade-Stufe gesperrt, so daß auch jetzt kein Strom durch den zweiten Zweig Z2 fließen kann.

Unverändert bleibt auch das Potential des Knotenpunktes K1 im zweiten Zweig Z2. D.h., der Knotenpunkt K1 bleibt wie in der Vorlade-Stufe auf Massepotential.

Damit bleiben das Ausgangssignal des ersten Inverters I1 auf dem Pegel 1, das Ausgangssignal des NOR-Gliedes NOR auf dem Pegel 0, und das Ausgangssignal des dritten Inverters I3 (das Ausgangssignal KOUT der gesamten Anordnung) auf dem Pegel 1, was seinerseits wiederum zur Folge hat, daß die Transistoren M9 und M10 leitend, und der Transistor M8 sperrend bleiben.

Wenn der Transistor NVM1 so programmiert ist, daß er in der Detektions-Stufe leitet, kann über den ersten Zweig Z1 ein Strom fließen. Die im ersten Zweig Z1 vorgesehenen Transistoren (insbesondere der Transistor NVM1) sind im betrachteten Beispiel so bemessen und so angesteuert, daß der über den ersten Zweig Z1 fließende Strom 11 μA beträgt.

Dieser Strom wird über die als Stromspiegel wirkenden Transistoren M3 und M4 auch im oberhalb des Knotenpunktes K1 liegenden Teil des zweiten Zweiges Z2 zum Fließen gebracht. Im unterhalb des Knotenpunktes K1 liegenden Teil des zweiten Zweiges Z2 fließt der bereits erwähnte Referenzstrom InCur.

Das Fließen dieses Stromes im zweiten Zweig Z2 beruht auf einer Stromspiegelung durch die als Stromspiegel wirkenden Transistoren M6 und M5; der Referenzstrom InCur wird durch den Transistor M6 gegen Masse zum Fließen gebracht und von dort unter Verwendung der Transistoren M6 und M5 in den zweiten Zweig Z2 gespiegelt. Der im unterhalb des Knotenpunktes K1 liegenden Teil des zweiten Zweiges Z2 fließende (Referenz)Strom ist gegenläufig zu dem im oberhalb des Knotenpunktes K1 liegenden Teil des zweiten Zweiges Z2 fließende Strom. Der im unterhalb des Knotenpunktes K1 liegenden Teil des zweiten Zweiges Z2 fließende (Referenz-)Strom ist dabei jedoch wesentlich kleiner als der im oberhalb des Knotenpunktes K1 liegenden Teil des zweiten Zweiges Z2 fließende Strom; er ist im betrachteten Beispiel nur halb so groß, beträgt also nur 5,5 μA.

Weil der im oberhalb des Knotenpunktes K1 liegenden Teil des zweiten Zweiges Z2 fließende Strom größer ist als der im unterhalb des Knotenpunktes K1 liegenden Teil des zweiten Zweiges Z2 fließende Strom, wird der Knotenpunkt K1 zum Versorgungsspannungspotential $V_{DD}$ hin gezogen.

Damit geht das Ausgangssignal des ersten Inverters I1 auf dem Pegel 0, das Ausgangssignal des NOR-Gliedes NOR auf dem Pegel 1 (das Ausgangssignal des zweiten Inverters I2 weist wegen READ = 1 ebenfalls den Pegel 0 auf), und das Ausgangssignal des dritten Inverters I3 (das Ausgangssignal KOUT der gesamten Anordnung) auf dem Pegel 0.

Durch den Pegel 1 des Ausgangssignals des NOR-Gliedes NOR wird der dadurch angesteuerte Transistor M10 in den sperrenden Zustand versetzt, wodurch der Stromfluß im ersten Zweig Z1 unterbrochen wird.

Zugleich wird durch den Pegel 0 des Ausgangssignals KOUT der parallel zu dem nun sperrenden Transistor M4 angeordneten Transistor M8 in den leitenden Zustand versetzt, wodurch der Knotenpunkt K1 auf hohem Potential gehalten wird. Gleichzeitig wird durch den Pegel 0 des Ausgangssignals KOUT der Transistor M9 in den sperrenden Zustand versetzt, wodurch auch durch den zweiten Zweig Z2 kein Strom mehr fließen kann, und wodurch der Knotenpunkt K1 ganz auf $V_{DD}$ gezogen wird.

Der durch die Anordnung zu detektierende Stromfluß, d.h. der über den Transistor NVM1 und die Bitleitung BL erfolgende Stromfluß und zur Detektierung dieses Stromflusses erforderliche Stromflüsse (insbesondere der durch den zweiten Zweig Z2 erfolgende Stromfluß) werden also nur so lange aufrechterhalten wie es zur Detektierung des zu detektierenden Stromes erforderlich ist. Die genannten Stromflüsse werden unmittelbar nach dem Erfassen, genauer gesagt im Ansprechen auf das Erfassen des zu detektierenden Stromflusses unterbunden.

Normalerweise, d.h. ohne die vorstehend beschriebene Unterbindung der Stromflüsse würden diese andauern, bis die den eigentlichen Lesevorgang repräsentierende Detektions-Stufe durch eine Veränderung des READ-Signals vom Pegel 1 auf den Pegel 0 beendet wird. Dadurch, daß die Stromflüsse bereits innerhalb der Detektions-Stufe unterbunden werden, fließen die betreffenden Ströme erheblich kürzer als es bislang der Fall ist. Dadurch lassen sich die Leistungsaufnahme und der Energieverbrauch von Speichereinrichtungen erheblich reduzieren.

Positiv auf die Leistungsaufnahme und den Energieverbrauch von Speichereinrichtungen wirkt es sich auch aus, wenn zusätzlich oder alternativ dafür gesorgt wird, daß der Knotenpunkt KBL nur etwa auf das Potential vorgeladen wird, das erforderlich ist, um den auf eine niedrige Schwellenspannung programmierten Transistor NVM1 zum Durchschalten zu bringen.

Dies wird im betrachteten Beispiel dadurch erreicht, daß der Knotenpunkt KBL über einen Transistor M21 mit einem sehr geringen Strom (im nA-Bereich) entladen wird. Ob ein solches Entladen durchgeführt wird, und wann ein solches Entladen beginnen und enden soll, kann im betrachteten Beispiel über einen durch einen Transistor M20 geschickten Strom (Signal MU) festgelegt werden; die Transistoren M20 und M21 sind zu einem Stromspiegel verschaltet, wobei der den Transistor 20 durchfließende Strom in den Transistor M21 gespiegelt wird. Bei geeigneter Dimensionierung und Ansteuerung der Transistoren M20 und M21 kann erreicht werden, daß der Knotenpunkt KBL mehr oder weniger genau so weit entladen wird, daß sich an diesem ein vorbestimmtes Soll-Potential einstellt. Das Soll-Potential ist vorzugsweise etwa das Potential, das sich auf der Bitleitung einstellt, wenn alle Transistoren im ersten Zweig Z1 leiten (der erste Zweig Z1 von dem zu erfassenden Strom durchflossen wird).

Durch ein wie beschrieben oder anders erfolgendes Entladen des Knotenpunktes KBL wird dem Umstand Rechnung getragen, daß es in der Praxis nicht oder jedenfalls nicht ohne weiteres möglich ist, das Vorladen des Knotenpunktes so zu begrenzen, daß sich dort das erwähnte Soll-Potential einstellt.

Dies kann am Beispiel des (Precharge-)Transistors M2 veranschaulicht werden: Um eine bestimmungsgemäße Funktion des Transistors in der Detektions-Stufe zu gewährleisten, muß für die an den Gateanschluß des Transistors M2 angelegte Spannung VCONST1 gelten:

$$VCONST1 = V_{th} + V_{KBLsoll}$$

wobei Vth die Thresholdspannung des Transistors M2 ist, und wobei $V_{KBLsoll}$ das erwähnte Soll-Potential ist, auf das der Knotenpunkt KBL gebracht sein muß, damit ein auf eine niedrige Schwellenspannung programmierte Transistor NVM1, aber nicht ein auf eine hohe Schwellenspannung programmierte Transistor NVM1 sicher zum Durchschalten gebracht und durchgeschaltet gehalten wird.

Im betrachteten Beispiel beträgt $V_{KBLsoll}$ etwa 0,6 V. Dieses Potential reicht aus, um einen auf eine niedrige Schwellenspannung programmierte Transistor NVM1 zum Durchschalten zu bringen und durchgeschaltet zu halten.

Wie vorstehend bereits erwähnt wurde, wird der Knotenpunkt KBL in der Vorlade-Stufe jedoch bis auf VCONST1, also auf etwa 1,2 V aufgeladen. Dadurch dauert es nach dem Beginn der Detektions-Stufe (nach dem Wechsel des READ-Signals vom Pegel 0 auf den Pegel 1) relativ lange, bis sich im Zweig Z1 der zu detektierende Strom einstellt. Wenn und so lange das Potential am Knotenpunkt KBL größer ist als VCONST1 - $V_{th}$, sperrt nämlich der Transistor M2 und verhindert so das Fließen des zu erfassenden Stromes. Dabei dauert es relativ lange, bis der Knotenpunkt KBL von VCONST1 auf VCONST1 - $V_{th}$ entladen ist, denn durch den Transistor NVM1 fließt in diesem Stadium nur ein die Bitleitungskapazität C allmählich umladender statischer Strom.

Wenn durch ein wie beschrieben erfolgendes Entladen des Knotenpunktes KBL das sich dort in der Vorlade-Stufe einstellende Potential auf etwa VCONST1 - $V_{th}$ gebracht wird, so stellt sich der zu detektierende Strom gleich zu Beginn der Detektions-Stufe (unmittelbar nach dem Wechsel des READ-Signals vom Pegel 0 auf den Pegel 1) ein.

Das sich am Knotenpunkt KBL einstellende Potential muß durch das Entladen nicht unbedingt auf etwa VCONST1 - $V_{th}$ gebracht werden. Es erweist sich schon als Vorteil wenn es nicht allzu viel größer als VCONST1 - $V_{th}$ ist. Damit läßt sich die Zeit zwischen dem Beginn der Vorlade-Stufe und dem Beginn des zu erfassenden Stromflusses mehr oder weniger weit reduzieren.

Ein frühes Auftreten des zu detektierenden Stromes innerhalb der Detektions-Stufen ermöglicht es, die Detektions-Zeit und damit auch die Länge der Detektions-Stufen zu verkürzen. Dies erweist sich als enormer Vorteil, weil sich dadurch auf verblüffend einfache Weise erheblich kürzere Speicherzugriffszeiten erzielen lassen. Kürzere Speicherzugriffszeiten ermöglichen die Realisierung von schneller arbeitenden Speichereinrichtungen und können unter Umständen (beispielsweise beim Einsatz in drahtlosen Chipkarten) dazu genutzt werden, die Speichereinrichtung oder das die Speichereinrichtung enthaltende System weniger lange in Betrieb zu setzen oder früher in eine energiesparende Bereitschafts-Betriebsart zu versetzen.

Die beschriebene Speichereinrichtung ist so mit einem Minimum an Energie betreibbar.

**Patentansprüche**

1. Speichereinrichtung mit Speicherzellen (NVM1, M1) zum Speichern von Daten, und mit einem Leseverstärker (M3-M6, I1-I3, NOR), durch welchen anhand der Größe und/oder der Richtung eines sich beim Auslesen einer Speicherzelle durch diese einstellenden Stromflußes der Inhalt der betreffenden Speicherzelle ermittelbar ist,
**dadurch gekennzeichnet,**
daß eine Stromabschalteinrichtung (M10) vorgesehen ist, die einen vorhandenen Stromfluß durch die auszulesende Speicherzelle im Ansprechen auf das Erkennen des Speicherzellen-Inhaltes unterbindet.

2. Speichereinrichtung nach Anspruch 1,
**dadurch gekennzeichnet,**
daß die Stromabschalteinrichtung (M10) einen zur auszulesenden Speicherzelle (NVM1, M1) in Reihe geschalteten Transistor umfaßt.

3. Speichereinrichtung nach Anspruch 1 oder 2,
**dadurch gekennzeichnet,**
daß die Stromabschalteinrichtung (M10) vom Leseverstärker (M3-M6, I1-13, NOR) gesteuert wird.

4. Speichereinrichtung nach einem der vorhergehenden Ansprüche,
**dadurch gekennzeichnet,**
daß ein den Inhalt der auszulesenden Speicherzelle (NVM1, M1) signalisierendes Signal (KOUT) des Leseverstärkers (M3-M6, I1-13, NOR) nach einem durch die Stromabschalteinrichtung (M10) erfolgten Unterbinden eines vorhandenen Stromflusses durch die auszulesende Speicherzelle in seinem vorherigen Zustand gehalten wird.

5. Speichereinrichtung nach einem der vorhergehenden Ansprüche,
**dadurch gekennzeichnet,**
daß ein durch die Stromabschalteinrichtung (M10) erfolgtes Unterbinden eines vorhandenen Stromflusses durch die auszulesende Speicherzelle (NVM1, M1) mit dem Beenden des Auslesevorganges der Speicherzelle beendet wird.

6. Speichereinrichtung mit Speicherzellen (NVM1, M1) zum Speichern von Daten, und mit einem Leseverstärker (M3-M6, I1-I3, NOR), durch welchen anhand der Größe und/oder der Richtung eines sich beim Auslesen einer Speicherzelle durch diese einstellenden Stromflusses der Inhalt der betreffenden Speicherzelle ermittelbar ist,
**dadurch gekennzeichnet,**
daß eine Entladevorrichtung (M20, M21) vorgesehen ist, welche einen vor dem Auslesen der Speicherzelle vorzuladenden Knotenpunkt (KBL) in dieser teilweise wieder entlädt.

7. Speichereinrichtung nach Anspruch 6,
**dadurch gekennzeichnet,**
daß der Knotenpunkt (KBL) Bestandteil einer der auszulesenden Speicherzelle zugeordneten Bitleitung (BL) ist.

8. Speichereinrichtung nach Anspruch 6 oder 7,
**dadurch gekennzeichnet,**
daß der Knotenpunkt (KBL) mit einem Anschluß eines in der Speicherzelle (NVM1, M1) enthaltenen Speichertransistors (NVM1) verbunden ist.

9. Speichereinrichtung nach einem der Ansprüche 6 bis 8,
**dadurch gekennzeichnet,**
daß die Entladevorrichtung (M20, M21) dazu ausgelegt ist, den Knotenpunkt (KBL) auf ein Potential zu entladen, welches sich dort einstellt, wenn die Speicherzelle (NVM1, M1) von dem vom Leseverstärker (M3-M6, I1-13, NOR) zu erfassenden Strom durchflossen wird.

10. Speichereinrichtung nach einem der Ansprüche 6 bis 9, **dadurch gekennzeichnet,**
daß das Entladen des Knotenpunktes (KBL) vor dem Beginn des Auslesens der Speicherzelle (NVM1, M1) durch den Leseverstärker erfolgt.

11. Speichereinrichtung nach einem der Ansprüche 6 bis 10,
**dadurch gekennzeichnet,**
daß das Entladen des Knotenpunktes (KBL) mit einem einstellbaren Strom erfolgt.

**Europäisches Patentamt**

## EUROPÄISCHER RECHERCHENBERICHT

Nummer der Anmeldung

EP 99 12 0074

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | EP 0 390 404 A (HUGHES MICROELECTRONICS LTD) 3. Oktober 1990 (1990-10-03) * das ganze Dokument * --- | 1-5 | G11C7/06 G11C16/26 |
| X | US 5 258 669 A (NAKASHIMA YASUHIRO) 2. November 1993 (1993-11-02) * Abbildungen 4,5 * --- | 6-11 | |
| X | US 5 834 953 A (GLASS KEVIN W ET AL) 10. November 1998 (1998-11-10) * Spalte 2, Zeile 32-39 * | 1,2 | |
| A | * Spalte 4, Zeile 9-14; Abbildungen 1,4 * ----- | 6-10 | |

RECHERCHIERTE SACHGEBIETE (Int.Cl.7)

G11C

Der vorliegende Recherchenbericht wurde für alle Patentansprüche erstellt

| Recherchenort | Abschlußdatum der Recherche | Prüfer |
|---|---|---|
| DEN HAAG | 15. Februar 2000 | Vidal Verdu, J. |

EPO FORM 1503 03.82 (P04C03)

**EP 1 094 465 A1**

## ANHANG ZUM EUROPÄISCHEN RECHERCHENBERICHT
## ÜBER DIE EUROPÄISCHE PATENTANMELDUNG NR.

EP 99 12 0074

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-02-2000

| Im Recherchenbericht angeführtes Patentdokument | | Datum der Veröffentlichung | Mitglied(er) der Patentfamilie | | Datum der Veröffentlichung |
|---|---|---|---|---|---|
| EP 0390404 | A | 03-10-1990 | DE | 69019867 D | 13-07-1995 |
| | | | DE | 69019867 T | 14-12-1995 |
| | | | US | 5031145 A | 09-07-1991 |
| US 5258669 | A | 02-11-1993 | JP | 4259991 A | 16-09-1992 |
| | | | KR | 9501430 B | 24-02-1995 |
| US 5834953 | A | 10-11-1998 | KEINE | | |

EPO FORM P0461

Für nähere Einzelheiten zu diesem Anhang : siehe Amtsblatt des Europäischen Patentamts, Nr.12/82